# EUROPÄISCHE PATENTSCHRIFT

(11) **EP 2 519 731 B1**
(45) Veröffentlichungstag und Bekanntmachung des Hinweises auf die Patenterteilung: **06.05.2015**
(21) Anmeldenummer: 10779274.9
(22) Anmeldetag: 04.11.2010
(51) Int. Cl.: F02M 51/06, F02M 55/00, H01L 41/053, H01L 41/083, H01L 41/12, F16F 1/02

(54) **EINSPRITZVENTIL FÜR EIN FLUID**
INJECTION VALVE FOR A FLUID
INJECTEUR POUR FLUIDE

(30) Priorität: 29.12.2009 DE 102009055370
(43) Veröffentlichungstag der Anmeldung: 07.11.2012
(73) Patentinhaber: Robert Bosch GmbH, 70442 Stuttgart (DE)
(72) Erfinder: SCHMIEDER, Dietmar, 71706 Markgroeningen (DE); JAKOBI, Andreas, 16372 Bursa (DE)
(86) Internationale Anmeldenummer: PCT/EP2010/066790
(87) Internationale Veröffentlichungsnummer: WO 2011/079987

(56) Entgegenhaltungen:
- EP-A1- 1 734 253
- DE-A1- 10 257 895
- DE-A1-102008 002 010

## Beschreibung

### Stand der Technik

Die Erfindung geht aus von einem Einspritzventil für ein Fluid, insbesondere für Kraftstoff, nach dem Oberbegriff des Anspruchs 1.

Bei einem bekannten Brennstoffeinspritzventil für Brennkraftmaschinen (DE 102 57 895 A1) ist das fluidführende Rohr, das den Fluidzulauf mit einer in einem zulauffernen Düsenkörper einem Ventilsitz vorgelagerten Ventilkammer verbindet, in das Ventilgehäuse integriert und verläuft parallel versetzt zu der Gehäuseachse. Das Ventilgehäuse umschließt einen kreiszylindrischen Hohlraum, in dem ein piezoelektrischer oder magnetostriktive Aktor zur Ventilbetätigung angeordnet ist. Die kreisringförmige Gehäusewand ist einseitig längsdurchgehend radial verdickt und ist in dem Verdickungsbereich mit einer Axialbohrung versehen, in der das Rohr geführt ist. Das Rohr ist am unteren Ende um etwa 90° umgebogen und in eine in der Ventilkammer mündende Radialöffnung im Düsenkörper eingesteckt und mit dem Düsenkörper verschweißt oder verlötet. An dem vom Düsenkörper abgekehrten Ende ist das Rohr an einen den Fluidzulauf bildenden Zulaufstutzen angesetzt und mit dem Zulaufstutzen fest verbunden.

Ein bekannter piezoelektrischer Aktor zur Steuerung eines Kraftstoffeinspritzventils (DE 103 19 599 A1) ist in einem als Rohrfeder ausgebildeten Hohlzylinder angeordnet und liegt mit seinen Stirnflächen an einer oberen und unteren Abdeckplatte an. Die beiden Abdeckplatten sind jeweils form- und/oder kraftschlüssig, z.B. durch Schweißen, fest mit dem Hohlzylinder verbunden, wobei vor dem Verschweißen der Hohlzylinder axial vorgespannt wird. Zur Erzielung der Federeigenschaft des Hohlzylinders ist in die Zylinderwand des Hohlzylinders eine Vielzahl von gleich ausgebildeten, knochenförmigen Ausnehmungen eingestanzt, die gleichmäßig verteilt angeordnet sind und eine gleiche lichte Querschnittsfläche aufweisen. Der Aktor stützt sich kraftschlüssig an den beiden Abdeckplatten ab und ist durch diese auf Druck belastet.

### Offenbarung der Erfindung

### Vorteile der Erfindung

Das erfindungsgemäße Einspritzventil mit den Merkmalen des Anspruchs 1 hat den Vorteil, dass durch die Zylinderwandöffnung im Hohlzylinder Platz für den Einbau des fluidführenden Rohrs innerhalb des Ventilgehäuses zwischen Gehäusewand und Aktor geschaffen ist und zugleich ein fertigungsgerechtes, als einfacher Drehkörper herstellbares Ventilgehäuse verwendet werden kann, dessen lichter Durchmesser nur wenig größer als der des den Aktor umgebenden Hohlzylinders ist. Der durch die Zylinderwandöffnung geschaffene Raum ist ausreichend, um einen brauchbaren Rohrdurchmesser des fluidführenden Rohrs zu erreichen, mit dem Druckabfälle im Zulaufbereich des Einspritzventils noch in akzeptablen Grenzen gehalten werden können.

Durch die in den weiteren Ansprüchen aufgeführten Maßnahmen sind vorteilhafte Weiterbildungen und Verbesserungen des im Anspruch 1 angegebene Einspritzventils möglich.

Gemäß einer vorteilhaften Ausführungsform der Erfindung weist der Hohlzylinder zur Herstellung seiner Federeigenschaft eine Vielzahl von über die Zylinderwand gleichmäßig verteilt angeordneten Ausnehmungen auf und ist zwischen zwei an seinen Stirnseiten befestigten Abdeckplatten axial vorgespannt, wodurch der stirnseitig an den Abdeckplatten anliegende Aktor axial druckbelastet ist. Der Hohlzylinder wird dabei als Stanz- und Biegeteil hergestellt. Die erfindungsgemäß vorgesehene, längsdurchgehende Öffnung in der Zylinderwand des Hohlzylinders führt dabei zu einer exzentrischen Krafteinleitung und damit zu einer Biegebeanspruchung, die den Aktor beschädigt. Dies wird gemäß vorteilhaften Ausführungsformen der Erfindung durch alternativen Maßnahmen kompensiert.

Gemäß einer ersten Ausführungsform der Erfindung ist der Hohlzylinder relativ zum Aktor so angeordnet, dass die Zylinderachse gegenüber der Aktorachse um ein Exzentrizitätsmaß hin zur Zylinderwandöffnung im Hohlzylinder verschoben ist. Das Exzentrizitätsmaß ist so gewählt, dass die stirnseitig vom Hohlzylinder auf den Aktor ausgeübte Druckkraft zentrisch auf die Achse des Aktors eingeleitet ist.

Gemäß einer alternativen Ausführungsform der Erfindung ist der Hohlzylinder koaxial zur Aktorachse angeordnet und der lichte Querschnitt der Ausnehmung im zylinderwandnahen Bereich des Hohlzylinders kleiner ist als der lichte Querschnitt der übrigen Ausnehmungen. Die Summe der kleineren lichten Querschnitte und die Summe der größeren lichten Querschnitte sind so aufeinander abgestimmt, dass die stirnseitig vom Hohlzylinder auf den Aktor ausgeübte Druckkraft zentrisch auf die Achse des Aktors eingeleitet ist.

Gemäß einer vorteilhaften Ausführungsform der Erfindung weist der Aktor einen Stapel aus piezoelektrischen oder magnetostriktiven Keramikelementen und einen den Stapel umschließende Aktorhülse auf, die in ihrem der Zylinderwandöffnung im Hohlzylinder zugekehrten Bereich abgeflacht ist. Durch diese Abflachung der Aktorhülse wird das Raumangebot für die Durchführung des fluidführenden Rohrs zwischen Gehäusewand und Aktor vergrößert.

Gemäß einer vorteilhaften Ausführungsform der Erfindung verlauft in der Gehäusewand des Ventilgehäuses ein der Zylinderwandöffnung im Hohlzylinder radial gegenüberliegender, zu der Zylinderwandöffnung hin offener, längsdurchgehender Kanal, in den das fluidführende Rohr radial hineinragt. Durch diese konstruktive Maßnahme kann der Durchmesser des zwischen Gehäusewand und Aktor hindurchgeführten Rohrs. deutlich vergrößert und der Druckabfall im Zulaufbereich des Ventils deutlich gesenkt werden. Beispielsweise kann damit bei einem Außendurchmesser des Ventilgehäuses von 20mm ein Rohr mit 4mm Außendurchmesser eingesetzt werden, das bei einer dem Einspritzdruck standhaltenden Wandstärke von ca. 0,8mm einen vorteilhaft großen Strömungsquerschnitt von ca. 3,8mm² aufweist.

Gemäß einer vorteilhaften Ausführungsform der Erfindung kann der Kanal in der Gehäusewand auf verschiedene Weise realisiert werden. Vorteilhaft ist dabei der Kanal von einer in die Gehäusewand des zylindrischen Ventilgehäuses eingeschnittene, axial längsdurchgehende Gehäusewandöffnung und einem um die Gehäusewand herumgelegten, fest mit den Ventilgehäuse verbunden Außenrohr gebildet. Alternativ kann der Kanal von einer in der Gehäusewand verlaufenden Axialnut mit vorzugsweise U-förmigem Nutquerschnitt gebildet sein.

Gemäß einer vorteilhaften Ausführungsform der Erfindung ist das im Ventilgehäuse zwischen Gehäusewand und Aktor hindurchgeführte Rohr stirnseitig koaxial einerseits an einem den Fluidzulauf bildenden Zulaufstutzen und andererseits an ein hohlzylindrischen Verbindungsstück jeweils fest angesetzt, z.B. mit Zulaufstutzen und Verbindungsstück verschweißt. Das Verbindungsstück ist in einer Gewindebohrung in Form eines Sacklochs mit Innengewinde, die in einen die Ventilkammer enthaltenden, an das Ventilgehäuse stirnseitig angesetzten Düsenkörper eingebracht ist, verschraubt. Im Düsenkörper ist eine Fluidverbindung zwischen der Gewindebohrung und der Ventilkammer hergestellt. Die Gewindebohrung ist mittels eines im Gewindebereich angeordneten Dichtungselements hermetisch abgedichtet. Durch die Gewindeverbindung zwischen Rohr und Düsenkörper und durch das in der Gewindebohrung angeordnete Dichtungselement ist die Verbindung zwischen Rohr und Düsenkörper hoch belastbar und hält den zunehmend geforderten hohen Kraftstoffdrücken im Einspritzventil mit zuverlässiger Dichtheit stand.

### Kurze Beschreibung der Zeichnungen

Die Erfindung ist anhand von in den Zeichnungen dargestellten Ausführungsbeispielen in der nachfolgenden Beschreibung näher erläutert. Es zeigen:
Figur 1 einen Längsschnitt eines Einspritzventils für ein Fluid,
Figur 2 einen Schnitt längs der Linie II - II in Figur 1, vergrößert dargestellt,
Figur 3 eine Draufsicht eines eine Rohrfeder bildenden Hohlzylinders im Einspritzventil gemäß Figur 1 in Richtung Pfeil III in Figur 2,
Figur 4 eine gleiche Darstellung wie in Figur 2 mit modifiziert angeordnetem Hohlzylinder,
Figur 5 einen Längsschnitt eines modifizierten Einspritzventils gemäß einem weiteren Ausführungsbeispiel,
Figur 6 einen Schnitt längs der Linie VI - VI in Figur 5, vergrößert dargestellt.

### Ausführungsformen der Erfindung

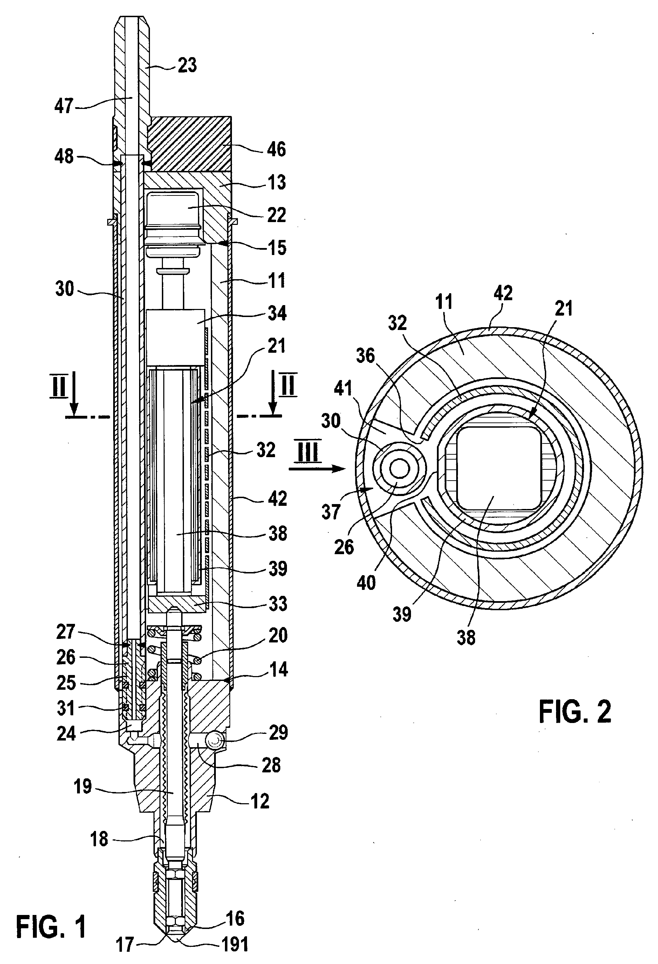

Das in Figur 1 im Längsschnitt dargestellte Einspritzventil für ein Fluid, z.B. für Kraftstoff in einer Kraftstoffversorgungsanlage für Brennkraftmaschinen, weist ein rohr- oder hülsenartiges Ventilgehäuse 11 auf, dessen eines Gehäuseende von einem Düsenkörper 12 abgeschlossen und dessen anderes Gehäuseende von einem Anschlussstück 13 abgedeckt ist. Düsenkörper 12 und Anschlussstück 13 sind fest mit dem Ventilgehäuse 11 verbunden, z.B. durch jeweils eine umlaufende Schweißnaht 14, 15. Am freien Ende des Düsenkörpers 12 ist eine von einem Ventilsitz 16 umschlossene Abspritzöffnung 17 ausgebildet. Dem Ventilsitz 16 ist eine Ventilkammer 18 vorgelagert. Durch die Ventilkammer 18 taucht eine im Düsenkörper 12 verschieblich geführte Ventilnadel 19 hindurch, die mit einem Schließkopf 191 von einer am Düsenkörper 12 und an der Ventilnadel 19 sich abstützenden Ventilschließfeder 20 unter Schließen der Abspritzöffnung 17 auf den Ventilsitz 16 aufgepresst wird. Zur Betätigung der nach außen gegen die Rückstellkraft der Ventilschließfeder 20 öffnenden Ventilnadel 19 dient ein piezoelektrischer oder magnetostriktiver Aktor 21, der in Reihe mit einem hydraulischen Koppler 22 in dem Ventilgehäuse 11 aufgenommen und zwischen Ventilnadel 19 und Anschlussstück 13 axial kraftschlüssig eingespannt ist. Aufbau und Funktion des Kopplers 22 ist z.B. in der DE 10 2007 028 490 A1 beschrieben.

An dem vom Anschlussstück 13 abgedeckten Gehäuseende des Ventilgehäuses 11 ist ein Fluidzulauf 47 in Form eines Zulaufstutzens 23 zum Aufstecken einer Kraftstoffzuleitung angeordnet, wobei der Zulaufstutzen 23 z.B. durch eine Kunststoffumspritzung 46 des Anschlussstücks 13 festgelegt ist. Ein durch das Ventilgehäuse 11 geführtes Rohr 30 stellt eine druckfeste Fluidverbindung zwischen dem Fluidzulauf 47 und der Ventilkammer 18 her. Das Rohr 30, das mit seinem einen Rohrende koaxial an den Zulaufstutzen 23 angesetzt und mit diesem fest verbunden ist (Schweißnaht 48), ist am Aktor 21 entlanggeführt und in einem Sackloch 24 mit Innengewinde verschraubt, das radial versetzt zur Gehäuseachse des Ventilgehäuses 11 in den Düsenkörper 12 eingebracht ist. Die Gewindeverbindung 25 zwischen Rohr 30 und Düsenkörper 12 ist dabei mit Hilfe eines gegenüber dem Rohr 30 wanddickeren, hohlzylindrischen Verbindungsstücks 26 hergestellt, das an das Rohrende angeschweißt oder angelötet ist (Schweißnaht 27) und mit einem Außengewinde versehen ist, das mit dem Innengewinde im Sackloch 24 die Gewindeverbindung 25 herstellt. Von dem Sackloch 24 aus ist unterhalb der Gewindeverbindung 25 eine Fluidverbindung zu der Ventilkammer 18 hergestellt. Diese ist mittels einer Querbohrung 28 realisiert, die im Sackloch 24, hier im Sacklochgrund, mündet. Die Querbohrung 28 ist radial in den Düsenkörper 12 eingebracht und am vom Sackloch 24 entfernten Ende mittels einer eingepressten Kugel 29 druckdicht verschlossen. In der Gewindeverbindung 25 ist mindestens ein Dichtungselement 31 angeordnet, das eine Fluidleckage aus dem Sackloch 24 heraus in das Innere des Ventilgehäuses 11 hinein, in dem der nicht kraftstoffresistente Aktor 21 einliegt, zuverlässig verhindert.

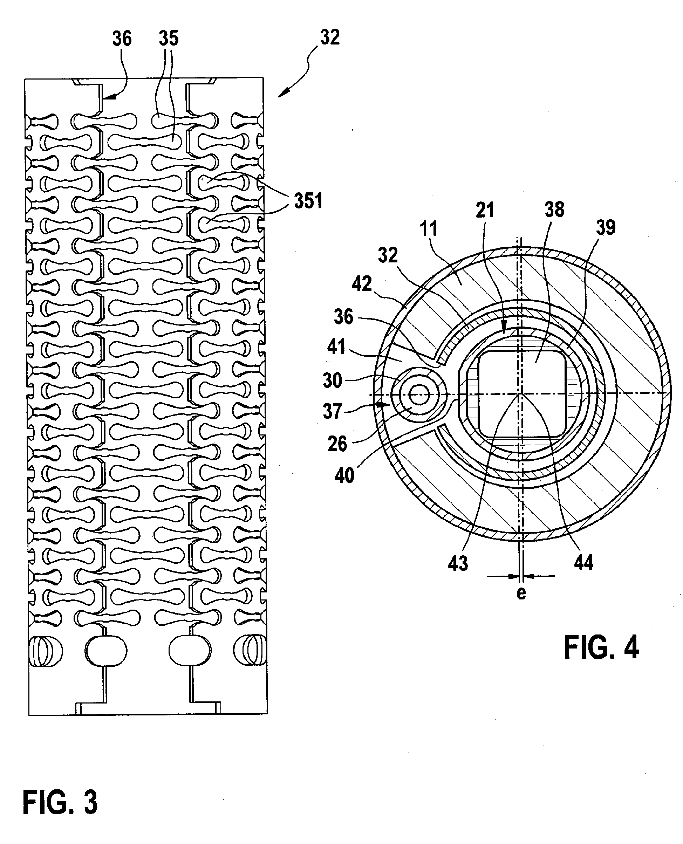

Der im Ventilgehäuse 11 koaxial angeordnete Aktor 21 ist in einem als vorgespannte Feder ausgebildeten Hohlzylinder 32, auch Rohrfeder genannt, aufgenommen, der mit seinen Stirnenden an einer unteren und oberen Abdeckplatte 33 bzw. 34 befestigt, z.B. verschweißt ist. Zur Erzielung der Federeigenschaft des Hohlzylinders 32 ist dessen Zylinderwand mit einer Vielzahl von Ausnehmungen 35 versehen, die über die Zylinderwand gleichmäßig verteilt angeordnet sind. Wie aus Figur 3 ersichtlich ist, weisen diese Ausnehmungen 35 eine knochenartige Form, können aber auch eine andere Formgestaltung besitzen. Der Hohlzylinder 32 ist zwischen den Abdeckplatten 33, 34 axial vorgespannt, was vor dem Verschweißen der Abdeckplatten 33, 34 mit dem Hohlzylinder 32 vorgenommen worden ist. Der einen Stapel 38 aus übereinanderliegenden, piezoelektrischen oder magnetostriktiven Keramikelementen aufweisende Aktor 21 liegt mit seinen Stirnenden an den beiden Abdeckplatten 33, 34 an, über die der Hohlzylinder 32 eine Druckkraft auf den Aktor 21 ausübt, so dass der Stapel 38 axial druckbelastet ist.

Um Platz zum Durchführen des Rohrs 30 durch das Ventilgehäuse 11 am Aktor 21 vorbei zu schaffen, ist in der Zylinderwand des Hohlzylinders 32 eine axial längsdurchgehende, breitschlitzige Zylinderwandöffnung 36 vorhanden, in die das im Ventilgehäuse 11 angeordnete Rohr 30 radial hineinragt (Figur 2). Im Ausführungsbeispiel der Figur 1 bis 3 ist der Hohlzylinder 32 koaxial zum Aktor 21 angeordnet. Um eine durch die Zylinderwandöffnung 36 bedingte, exzentrische Krafteinleitung der stirnseitig am Aktor 21 angreifenden Druckkraft in den Aktor 21 zu vermeiden, sind - wie dies aus Figur 3 ersichtlich ist - von den Ausnehmungen 35 solche Ausnehmungen, die im zylinderwandöffnungsnahen Bereich des Hohlzylinders 32 liegen (In Figur 3 mit 351 bezeichnet) mit einem kleineren Querschnitt ausgestattet als die übrigen Ausnehmungen 35. Die Summe der Querschnitte der Ausnehmungen 351 und die Summe der Querschnitte der übrigen Ausnehmungen 35 sind dabei so aufeinander abgestimmt, dass die von dem Hohlzylinder 32 erzeugte, stirnseitig auf den Aktor 21 wirkende Druckkraft zentrisch auf den Aktor 21 übertragen wird, also zentrisch in die Achse des Aktors 21 eingeleitet ist.

Um das Raumangebot für das Durchführen eines im Durchmesser größeren Rohrs 30 zu verbessern und damit den Druckabfall im Zulaufbereich des Einspritzventils weiter zu reduzieren, verläuft einerseits in der Gehäusewand des Ventilgehäuses 11 ein der Zylinderwandöffnung 36 im Hohlzylinder 32 radial gegenüberliegender, zu der Zylinderwandöffnung 36 hin offener, längsdurchgehender Kanal 37 und ist andererseits eine den Stapel 38 des Aktors 21 umschließende Aktorhülse 39 in ihrer der Zylinderwandöffnung 36 im Hohlzylinder 32 zugekehrten Bereich abgeflacht. Das durchmessergrößere Rohr 30 ragt radial nunmehr in den Kanal 37 hinein und durch die Zylinderwandöffnung 36 hindurch bis nahe an die Abflachung 40 an der Aktorhülse 39.

Im Ausführungsbeispiel der Figur 1 und 2 ist der Kanal 37 von einer in der Gehäusewand des Ventilgehäuses 11 eingeschnittenen, axial längsdurchgehenden Gehäusewandöffnung 41 und einen um die Gehäusewand herumgelegten, fest mit dem Ventilgehäuse 11 verbunden Außenrohr 42 gebildet.

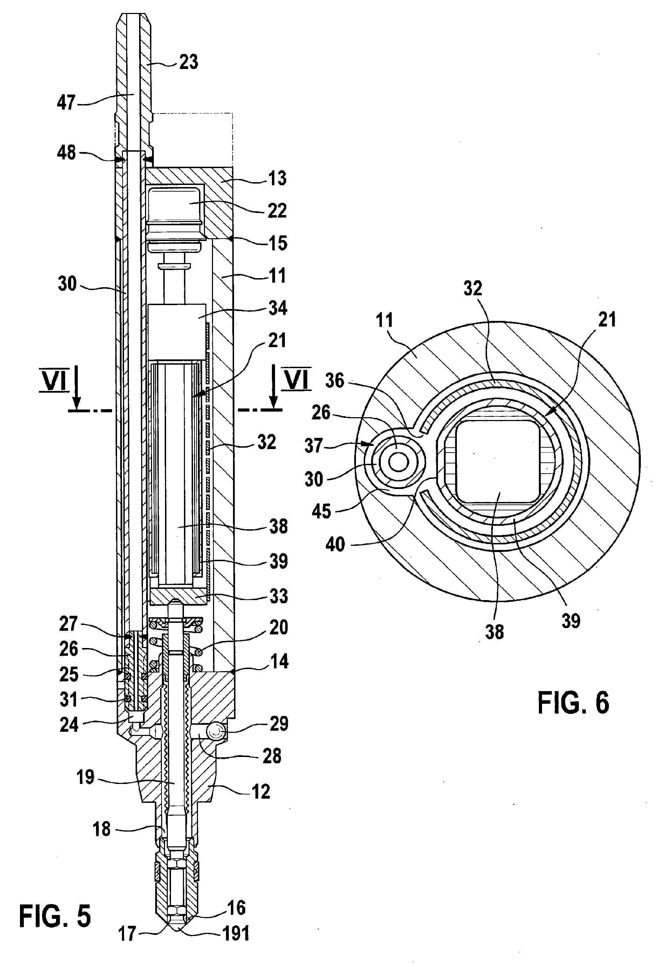

Das in Figur 5 und 6 dargestellte, modifizierte Kraftstoffeinspritzventil unterscheidet sich von dem zuvor beschriebenen Kraftstoffeinspritzventil nur dadurch, dass der Kanal 37 in der Gehäusewand des Ventilgehäuses 11 für die Durchführung des Rohrs 30 durch das Ventilgehäuse 11 von einer in der Gehäusewand verlaufenden Axialnut 45 gebildet ist. Dadurch kann das zuvor beschriebene Außenrohr 42 zur Abdeckung der Gehäusewandöffnung 41 entfallen. Die Axialnut 45 weist vorzugsweise einen U-förmigen Nutquerschnitt auf, dessen Rundung an den Außendurchmesser des Rohrs 30 angepasst ist.

Bei einer in Figur 4 dargestellten Modifizierung des Einspritzventils in Figur 1 oder Figur 5 ist der eine Rohrfeder darstellende Hohlzylinder 32 zum Aufbringen einer axialen Druckkraft auf den Aktor 21 in seiner Zylinderwand ebenfalls mit einer Vielzahl von gleichmäßig über die Zylinderwand verteilt angeordneten "knochenartigen" Ausnehmungen 35, wie sie in Figur 3 dargestellt sind, versehen. Im Unterschied zu Figur 3 sind aber alle Ausnehmungen 35 gleich ausgebildet und weisen einen identischen lichten Querschnitt auf. Um die durch die Zylinderwandöffnung 36 ausgelöste, exzentrische Krafteinleitung in den Aktor 21 zu vermeiden, ist hier der Hohlzylinder 32 relativ zu dem koaxial zur Gehäuseachse liegenden Aktor 21 so angeordnet, dass die Zylinderachse 43 des Hohlzylinders 32 gegenüber der Aktorachse 44 des Aktors 21 um ein Exzentrizitätsmaß e hin zur Zylinderwandöffnung 36 verschoben ist. Das Exzentrizitätsmaß e ist so bemessen, dass die vom Hohlzylinder 32 erzeugte Druckkkraft zentrisch auf den Aktor 21 übertragen wird, also zentrisch in die Aktorachse 44 eingeleitet ist.

Das Ventilgehäuse 11 kann ein Drehteil sein, ist aber vorzugsweise als Stanzbiegeteil gefertigt, das nach dem Stanzen geprägt und gerollt wird.

Bei dem in Fig. 1 und 2 dargestellten Einspritzventil wird das Stanzbiegeteil, zwischen dessen einander zugekehrten axialen Stoßkanten die Gehäusewandöffnung 41 verbleibt, in das Außenrohr 42 eingesetzt.

Bei dem in Fig. 5 und 6 dargestellten Einspritzventil liegen die einander zugekehrten Stoßkanten nach Rollen einander und werden miteinander verschweißt, so dass eine axial verlaufende Schweißnaht entsteht. Vorzugsweise liegt die Schweißnaht im Nutgrund der Axialnut 45.

## Patentansprüche

1. Einspritzventil für ein Fluid, insbesondere für Kraftstoff, mit einem Ventilgehäuse (11), mit einem Fluidzulauf (47), einer Ventilkammer (18) mit Abspritzöffnung (17), einem im Ventilgehäuse (11) angeordneten piezoelektrischen oder magnetostriktiven Aktor (21) und mit einem Fluidzulauf (47) und Ventilkammer (18) verbindenden, fluidführenden Rohr (30), das im Ventilgehäuse (11) am Aktor (21) vorbeilaufend angeordnet ist, **dadurch gekennzeichnet, dass** ein den Aktor (21) umgebender Hohlzylinder (32), der als vorgespannte Feder eine auf den Aktor (21) wirkende Druckkraft erzeugt, mit einer axial längsdurchgehenden Zylinderwandöffnung (36) versehen ist und die Anordnung des Rohrs (30) im Ventilgehäuse (11) so vorgenommen ist, dass das fluidführende Rohr (30) radial in die Zylinderöffnung (36) hineinragt.

2. Einspritzventil nach Anspruch 1, **dadurch gekennzeichnet, dass** der Hohlzylinder (32) eine Vielzahl von über die Zylinderwand gleichmäßig verteilt angeordneten Ausnehmungen (35) aufweist und zwischen zwei an seinen Stirnseiten befestigten Abdeckplatten (33, 34) axial vorgespannt ist, an denen der Aktor (21) sich stirnseitig abstützt.

3. Einspitzventil nach Anspruch 2, **dadurch gekennzeichnet, dass** der Hohlzylinder (32) relativ zum Aktor (21) so angeordnet ist, dass die Zylinderachse (43) des Hohlzylinders (32) gegenüber der Aktorachse (44) des Aktors (21) um ein Exzentrizitätsmaß (e) hin zur Zylinderwandöffnung (36) verschoben ist, und dass das Exzentrizitätsmaß (e) so bemessen ist, dass die vom Hohlzylinder erzeugte Druckkraft konzentrisch in die Aktorachse (44) des Aktors (21) eingeleitet ist.

4. Einspritzventil nach Anspruch 2, **dadurch gekennzeichnet, dass** der Hohlzylinder (32) koaxial zum Aktor (21) angeordnet ist, dass der lichte Querschnitt der Ausnehmungen (351) im zylinderwandöffnungsnahen Bereich des Hohlzylinders (32) kleiner ist als der lichte Querschnitt der übrigen Ausnehmungen (35) und dass die Summe der lichten Querschnitte der kleineren Ausnehmungen (351) und die Summe der Querschnitte der übrigen Ausnehmungen (35) so aufeinander abgestimmt sind, dass die vom Hohlzylinder (32) erzeugte axiale Druckkraft zentrisch auf die Achse des Aktors (21) eingeleitet ist.

5. Einspritzventil nach einem der Ansprüche 1 bis 5, **dadurch gekennzeichnet, dass** der Aktor (21) einen Stapel (38) aus piezoelektrischen oder magnetostriktiven Keramikelementen und eine den Stapel (38) umschließende Aktorhülse (39) aufweist, die in ihrem der Zylinderwandöffnung (36) zugekehrten Bereich abgeflacht ist.

6. Einspritzventil nach einem der Ansprüche 1 bis 5, **dadurch gekennzeichnet, dass** in der Gehäusewand des Ventilgehäuses (11) ein der Zylinderwandöffnung (36) radial gegenüberliegender, zu dieser hin offener, längsdurchgehender Kanal (37) vorhanden ist, in den das fluidführende Rohr (30) radial hineinragt.

7. Einspritzventil nach Anspruch 6, **dadurch gekennzeichnet, dass** der Kanal (37) von einer in die Gehäusewand des Ventilgehäuses (11) eingeschnittenen, axial längsdurchgehden Gehäusewandöffnung (41) und einem um die Gehäusewand herumgelegten, fest mit dem Ventilgehäuse (11) verbundenen Außenrohr (42) gebildet ist.

8. Einspritzventil nach Anspruch 6, **dadurch gekennzeichnet, dass** der Kanal (37) von einer in der Gehäusewand des Ventilgehäuses (11) verlaufenden Nut (45) mit einem vorzugsweise U-förmigen Nutquerschnitt gebildet ist.

9. Einspritzventil nach einem der Ansprüche 1 bis 8, **dadurch gekennzeichnet, dass** das fluidführende Rohr (30) stirnseitig koaxial einerseits an einen den Fluidzulauf (47) bildenden Zulaufstutzen (23) und andererseits an ein hohlzylindrisches Verbindungsstück (26) jeweils fest angesetzt ist, dass das Verbindungsstück (26) in ein mit einem Innengewinde versehenes Sackloch (24) in einem die Ventilkammer (18) enthaltenden, am Gehäuse befestigten Düsenkörper (12) eingeschraubt und im Düsenkörper (12) eine Fluidverbindung zwischen dem Sackloch (24) und der Ventilkammer (18) hergestellt ist, und dass das Sackloch (24) mittels mindestens eines im Gewindebereich angeordneten Dichtungselements (31) abgedichtet ist.

10. Einspritzventil nach einem der Ansprüche 1 - 9, **dadurch gekennzeichnet, dass** das Ventilgehäuse (11) als geprägtes und gerolltes Stanblechteil ausgebildet ist.

## Claims

1. Injection valve for a fluid, in particular for fuel, having a valve housing (11), having a fluid inlet (47), having a valve chamber (18) with discharge opening (17), having a piezoelectric or magnetostrictive actuator (21) arranged in the valve housing (11), and having a fluid-conducting pipe (30) which connects a fluid inlet (47) and valve chamber (18) and which is arranged in the valve housing (11) so as to run past the actuator (21), **characterized in that** a hollow cylinder (32) which surrounds the actuator (21) and which, as a preloaded spring, generates a compressive force which acts on the actuator (21) is equipped with a cylinder wall opening (36) extending over the entire axial length, and the arrangement of the pipe (30) in the valve housing (11) is such that the fluid-conducting pipe (30) protrudes radially into the cylinder opening (36).

2. Injection valve according to Claim 1, **characterized in that** the hollow cylinder (32) has a multiplicity of recesses (35) arranged so as to be distributed uniformly over the cylinder wall and is preloaded axially between two cover plates (33, 34) which are fastened to the end sides of said hollow cylinder and on which the actuator (21) is supported at the end sides.

3. Injection valve according to Claim 2, **characterized in that** the hollow cylinder (32) is arranged relative to the actuator (21) such that the cylinder axis (43) of the hollow cylinder (32) is offset relative to the actuator axis (44) of the actuator (21) toward the cylinder wall opening (36) by an eccentricity dimension (e), and **in that** the eccentricity dimension (e) is such that the compressive force generated by the hollow cylinder is introduced concentrically into the actuator axis (44) of the actuator (21).

4. Injection valve according to Claim 2, **characterized in that** the hollow cylinder (32) is arranged coaxially with respect to the actuator (21), **in that** the clear cross section of the recesses (351) in the region of the hollow cylinder (32) close to the cylinder wall opening is smaller than the clear cross section of the other recesses (35), and **in that** the sum of the clear cross sections of the relatively small recesses (351) and the sum of the cross sections of the other recesses (35) are coordinated with one another such that the axial compressive force generated by the hollow cylinder (32) is introduced centrally onto the axis of the actuator (21).

5. Injection valve according to one of Claims 1 to 5, **characterized in that** the actuator (21) has a stack (38) of piezoelectric or magnetostrictive ceramic elements and has an actuator sleeve (39) which surrounds the stack (38) and which is flattened in its region facing toward the cylinder wall opening (36).

6. Injection valve according to one of Claims 1 to 5, **characterized in that**, in the housing wall of the valve housing (11), there is provided a duct (37) which is situated radially opposite the cylinder wall opening (36) and which is open toward said cylinder wall opening and which extends over the entire length and into which the fluid-conducting pipe (30) protrudes radially.

7. Injection valve according to Claim 6, **characterized in that** the duct (37) is formed by a housing wall opening (41), which is cut into the housing wall of the valve housing (11) and which extends over the entire axial length, and by an outer pipe (42), which is placed around the housing wall and which is fixedly connected to the valve housing (11).

8. Injection valve according to Claim 6, **characterized in that** the duct (37) is formed by a groove (45) which runs in the housing wall of the valve housing (11) and which has a preferably U-shaped groove cross section.

9. Injection valve according to one of Claims 1 to 8, **characterized in that** the fluid-conducting pipe (30) is, at the end sides, coaxially attached fixedly in each case at one side to an inlet connector (23) which forms the fluid inlet (47) and at the other side to a hollow cylindrical connecting piece (26), **in that** the connecting piece (26) is screwed into a blind bore (24), provided with an internal thread, in a nozzle body (12) which comprises the valve chamber (18) and which is fastened to the housing, and in the nozzle body (12), a fluid connection is produced between the blind bore (24) and the valve chamber (18), and **in that** the blind bore (24) is sealed off by means of at least one seal element (31) arranged in the threaded region.

10. Injection valve according to one of Claims 1 - 9, **characterized in that** the valve housing (11) is in the form of a stamped and rolled punched metal sheet.

## Revendications

1. Soupape d'injection pour un fluide, en particulier pour du carburant, comprenant un boîtier de soupape (11), avec une entrée de fluide (47), une chambre de soupape (18) avec une ouverture de pulvérisation (17), un actionneur piézoélectrique ou magnétostrictif (21) disposé dans le boîtier de soupape (11) et un tube (30) conduisant le fluide, reliant l'entrée de fluide (47) et la chambre de soupape (18), lequel est disposé de manière à passer devant l'actionneur (21) dans le boîtier de soupape (11), **caractérisée en ce qu'**un cylindre creux (32) entourant l'actionneur (21), qui, en tant que ressort précontraint, produit une force de pression agissant sur l'actionneur (21), est pourvu d'une ouverture de paroi de cylindre (36) axialement longitudinale et l'agencement du tube (30) dans le boîtier de soupape (11) est effectué de telle sorte que le tube (30) conduisant le fluide pénètre radialement dans l'ouverture de cylindre (36).

2. Soupape d'injection selon la revendication 1, **caractérisée en ce que** le cylindre creux (32) présente une pluralité d'évidements (35) disposés de manière répartie uniformément sur la paroi de cylindre et est précontraint axialement entre deux plaques de recouvrement (33, 34) fixées à ses côtés frontaux, au niveau desquelles l'actionneur (21) s'appuie du côté frontal.

3. Soupape d'injection selon la revendication 2, **caractérisée en ce que** le cylindre creux (32) est disposé par rapport à l'actionneur (21) de telle sorte que l'axe de cylindre (43) du cylindre creux (32) soit déplacé vers l'ouverture de la paroi de cylindre (36) d'une dimension d'excentricité (e) par rapport à l'axe d'actionneur (44) de l'actionneur (21), et **en ce que** la dimension d'excentricité (e) est dimensionnée de telle sorte que la force de pression produite par le cylindre creux soit introduite concentriquement dans l'axe d'actionneur (44) de l'actionneur (21).

4. Soupape d'injection selon la revendication 2, **caractérisée en ce que** le cylindre creux (32) est disposé coaxialement par rapport à l'actionneur (21), **en ce que** la section transversale intérieure des évidements (351) dans la région du cylindre creux (32) proche de l'ouverture de la paroi de cylindre est inférieure à la section transversale intérieure des autres évidements (35) et **en ce que** la somme des sections transversales intérieures des plus petits évidements (351) et la somme des sections transversales des autres évidements (35) sont adaptées l'une à l'autre de telle sorte que la force de pression axiale produite par le cylindre creux (32) soit introduite centralement sur l'axe de l'actionneur (21).

5. Soupape d'injection selon l'une quelconque des revendications 1 à 5, **caractérisée en ce que** l'actionneur (21) présente une pile (38) d'éléments en céramique piézoélectriques ou magnétostrictifs et une douille d'actionneur (39) entourant la pile (38), laquelle est aplatie dans sa région tournée vers l'ouverture de la paroi de cylindre (36).

6. Soupape d'injection selon l'une quelconque des revendications 1 à 5, **caractérisée en ce que** dans la paroi de boîtier du boîtier de soupape (11) est prévu un canal longitudinal (37) radialement opposé à l'ouverture de la paroi de cylindre (36), ouvert vers celle-ci, dans lequel pénètre radialement le tube (30) conduisant le fluide.

7. Soupape d'injection selon la revendication 6, **caractérisée en ce que** le canal (37) est formé par une ouverture de paroi de boîtier (41) axialement longitudinale, découpée dans la paroi de boîtier du boîtier de soupape (11), et par un tube extérieur (42) placé autour de la paroi de boîtier, connecté fixement au boîtier de soupape (11).

8. Soupape d'injection selon la revendication 6, **caractérisée en ce que** le canal (37) est formé par une rainure (45) s'étendant dans la paroi de boîtier du boîtier de soupape (11) avec une section transversale de rainure de préférence en forme de U.

9. Soupape d'injection selon l'une quelconque des revendications 1 à 8, **caractérisée en ce que** le tube (30) conduisant le fluide est à chaque fois placé fixement du côté frontal coaxialement d'une part au niveau d'une tubulure d'alimentation (23) formant l'entrée de fluide (47) et d'autre part au niveau d'une pièce de connexion (26) cylindrique creuse, **en ce que** la pièce de connexion (26) est vissée dans un trou borgne (24) pourvu d'un filetage interne dans un corps de buse (12) fixé au boîtier, contenant la chambre de soupape (18), et une connexion fluidique entre le trou borgne (24) et la chambre de soupape (18) est établie dans le corps de buse (12), et **en ce que** le trou borgne (24) est étanchéifié au moyen d'au moins un élément d'étanchéité (31) disposé dans la région filetée.

10. Soupape d'injection selon l'une quelconque des revendications 1 à 9, **caractérisée en ce que** le boîtier de soupape (11) est réalisé sous forme de pièce en tôle découpée matricée et roulée.
